Europäisches Patentamt

European Patent Office

Office européen des brevets

(11) Veröffentlichungsnummer: **0 307 608 B1**

## (12) EUROPÄISCHE PATENTSCHRIFT

(45) Veröffentlichungstag der Patentschrift: **13.05.92**

(51) Int. Cl.⁵: **C30B 33/00**

(21) Anmeldenummer: **88112733.6**

(22) Anmeldetag: **04.08.88**

(54) **Anordnung zur Durchführung eines Ausheilprozesses an einer Halbleiterscheibe und Verfahren zum Ausheilen einer Halbleiterscheibe.**

(30) Priorität: **16.09.87 DE 3731148**

(43) Veröffentlichungstag der Anmeldung:
**22.03.89 Patentblatt 89/12**

(45) Bekanntmachung des Hinweises auf die Patenterteilung:
**13.05.92 Patentblatt 92/20**

(84) Benannte Vertragsstaaten:
**DE FR GB NL**

(56) Entgegenhaltungen:
**GB-A- 2 160 355**
**US-A- 4 331 485**
**US-A- 4 481 406**

**SOLID STATE ELECTRONICS, Band 26, Nr. 4, 1983, Seiten 313-317, Pergamon Press Ltd, Oxford, GB; J.D. GRANGE et al.: "Capless annealing of silicon implanted gallium arsenide"**

**APPLIED PHYSICS LETTERS, Band 47, Nr. 2, 15. Juli 1985, Seiten 120-122, American Institute of Physics, New York, US; H. KANBER et al.: "Rapid thermal annealing of Si implanted**

**GaAs for power field-effect transistors"**

(73) Patentinhaber: **SIEMENS AKTIENGESELL-SCHAFT**
**Wittelsbacherplatz 2**
**W-8000 München 2(DE)**

(72) Erfinder: **Gisdakis, Spyridon, Dipl.-Phys.**
**Plettstrasse 9**
**W-8000 München 83(DE)**
Erfinder: **Hoepfner, Joachim, Dipl.-Ing.**
**Magdalenenstrasse 5**
**W-8033 Planegg(DE)**

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

Rank Xerox (UK) Business Services
(3.08/2.19/2.0)

## Beschreibung

Die Erfindung betrifft eine Anordnung zur Durchführung eines Ausheilprozesses an einer Halbleiterscheibe und ein Verfahren zum Ausheilen einer Halbleiterscheibe.

Es ist bekannt, Halbleiterscheiben einer Wärmebehandlung zu unterziehen, um Kristallfehler auszuheilen, die z. B. beim Implantieren entstanden sind. Beim Ausheilen von implantierten Schichten muß gewährleistet sein, daß die eingestellten Dotierungsprofile weitgehend erhalten bleiben und daß die Schichtstrukturen nicht verfließen. Ferner wird im Fall hoher Dotierungen die Ausscheidungsbildung unterdrückt. Verfahren, die diese Bedingungen erfüllen, sind bekannt (siehe z. B. D. O. Sedgwick, Short Time Annealing, ECS-Fall Meeting, Okt. 82). Bei den Rapid-Thermal-Processing-(RTP)-Verfahren wird nur die auszuheilende Halbleiterscheibe und evtl. eine Referenzscheibe auf hohe Temperatur gebracht. Dabei erfolgt die Erwärmung sehr schnell mit Temperaturgradienten von z. B. $10^3$ °C/sek. Die Scheiben werden dieser hohen Temperatur, die z. B. ca. 900°C beträgt, für kurze Zeit, z. B. etwa 5-20 Sek., ausgesetzt und anschließend abgekühlt. Die Energiezufuhr in die Halbleiterscheibe geschieht z. B. durch Einkoppelung von Lichtenergie einer starken Lichtquelle, z. B. eines Lasers oder einer Lampe, oder durch eine elektrische Widerstandsheizung mit geringer Wärmekapazität. Die Halbleiterscheibe befindet sich während des Verfahrens in einer Reaktionskammer, die z. B. aus Quarzglas besteht. Der Ausheilprozeß findet in inerter Atmosphäre oder im Vakuum statt. Bei diesem Vorgehen wird die diffusionsbedingte Störstellenumverteilung wegen der kurzen Temperzeit unterdrückt. Damit ist sichergestellt, daß die obengenannten Forderungen erfüllt sind. Bei diesen RTP-Verfahren besteht während des Ausheilvorgangs ein großer Temperaturgradient zwischen der Halbleiterscheibe, die auf die Ausheiltemperatur aufgeheizt ist, und der Kammerwand, die Zimmertemperatur hat. Wenn von der Halbleiterscheibe Halbleitermaterial abdampft, schlägt es sich auf der Kammerwand nieder. Dieser Niederschlag führt bei einer Aufheizung durch Lichteinkoppelung zu Temperaturinhomogenitäten, da das Licht teilweise von dem Niederschlag absorbiert wird. Die Temperaturerfassung und -regelung durch Pyrometer wird fehlerhaft. Ferner wird der Aufheizprozeß verzögert.

Beim Ausheilen von Halbleiterscheiben, die aus einem Verbindungshalbleiter, insbesondere einer III/V-Verbindung, bestehen, tritt ein weiteres Problem auf. Da die Elemente der Verbindung unterschiedliche Dampfdrücke haben, entweicht das leichterflüchtige Element zuerst. Es führt zu einer unerwünschten Oberflächenerosion der Halbleiterscheiben.

Dieser Nachteil kann vermindert werden, wenn die auszuheilende Halbleiterscheibe zwischen z. B. zwei Halbleiterscheiben oder Quarzplatten eingebettet wird (s. z. B. H. Kanber et al, Appl. Phys. Lett 47 (2), Jul. 85, S. 120 ff), die auch auf die Ausheiltemperatur aufgeheizt werden. Dadurch kann die Oberflächenerosion vermindert werden. Durch dieses Vorgehen wird die Wärmekapazität des Systems vergrößert und der Wärmefluß in die Halbleiterscheibe erschwert.

Die Oberflächenerosion kann vermieden werden, wenn die Halbleiterscheibe beim Ausheilen mit einer Abdeckschicht aus z. B. $Si_3N_4$ geschützt wird (s. z. B. H. Kanber et al, Appl. Phys. Lett 47 - (2), Jul. 85, S. 120 ff, M. Kuzuhara et al, Mat. Res. Soc. Symp. Proc. Vol. 23 (1984), S. 651 ff). Dieses Vorgehen hat aber den Nachteil, daß mechanische Spannungen und Störstellenumverteilungen in der Halbleiterscheibe auftreten.

Die Oberflächenerosion kann auch ohne Abdeckschicht in den sogenannten Capless-Annealing-Verfahren (s. z. B. J. D. Grange et al, Solid State Electronics, Vol. 26, Nr. 4, 1983, S. 313 ff) vermieden werden. Dabei findet der Ausheilprozeß in einer Atmosphäre statt, die einen Überdruck des leichterflüchtigen Elements enthält. Der Überdruck, der ein Abdampfen der leichter flüchtigen Komponente verhindert, entsteht durch Aufspalten einer gasförmigen Wasserstoffverbindung des leichterflüchtigen Elements, die im Schutzgas enthalten ist, bei der Ausheiltemperatur. Diese Verfahren haben den Nachteil, daß es während der dabei benötigten Heizzeiten (Ausheilzeit: etwa 10-60 Min., Aufheizzeit: etwa 15 Min.) zur Diffusion von Störstellen und damit zur teilweisen Zerstörung der Dotierungsprofile kommt.

Eine Kombination des RTP-Verfahrens mit dem Capless-Annealing-Verfahren, bei der die Reaktionskammer im RTP-Verfahren mit der oben erläuterten Nasserstoffverbindung gefüllt wird, ist nicht sinnvoll, da die Aufheiz- und Ausheilzeit im RTP-Verfahren zu kurz ist zum Aufspalten der Wasserstoffverbindung und zum Ausbilden des Überdrucks der leichterflüchtigen Komponente.

In der US-Patentschrift 4 331 485 ist ein Verfahren für die Hitzebehandlung von Halbleitermaterial mittels CW-Lampen beschrieben. Für dieses Verfahren wird eine Anordnung benutzt, bei der die zu behandelnde Halbleiterscheibe auf einem Träger befestigt wird und eine CW-Lampe mittels eines Schraubengetriebes über die Halbleiterscheibe gefahren wird. Weil die Lichtintensität dieser Lampe nicht ausreicht, um ein rasches Ausheilen der Dotierung des Halbleitermateriales zu ermöglichen, wird die Halbleiterscheibe zuvor durch eine in dem Träger eingebaute elektrische Widerstandsheizung soweit erwärmt, daß zwar noch keine Wanderung von Dotierstoffatomen in dem Material auftritt, andererseits die Lichtintensität der CW-Lampe für ein Ausheilen ausreicht. Die vorstehend beschriebenen Nachteile herkömmlicher Anlagen zum Ausheilen von Halbleitermaterial werden durch diese Anordnung nicht beseitigt.

Der Erfindung liegt die Aufgabe zugrunde, ein verbessertes Ausheilverfahren und eine verbesserte Anordnung, in der das Ausheilverfahren durchgeführt wird, anzugeben.

Die Aufgabe wird erfindungsgemäß mit einer Anordnung nach Anspruch 1 gelöst. Die Aufgabe wird weiterhin mit einem Verfahren nach Anspruch 12 gelöst.

In der Erfindung werden die Vorteile des RTP-Verfahrens mit den Vorteilen des Capless-Annealing-Verfahrens dadurch gekoppelt, daß die Reaktionskammer auf eine Grundtemperatur aufgeheizt wird. Die Grundtemperatur ist so gewählt, daß Niederschläge auf der Kammerwand verhindert werden und daß, im Fall einer Wasserstoffverbindung als Inertgas, die Wasserstoffverbindung aufspaltet und dabei ein Überdruck der leichterflüchtigen Komponente entsteht. Da die Halbleiterscheibe selektiv auf die Ausheiltemperatur aufgeheizt wird, ist das aufzuheizende System klein, und es werden nur kurze Aufheizzeiten benötigt.

Da das Gasversorgungssystem nach Anspruch 12 regelbar ist, läßt sich gezielt der erforderliche Druck des Inertgases einstellen. Insbesondere kann der Überdruck der leichterflüchtigen Komponente genau auf die Halbleiterscheibe angepaßt werden.

Die Anordnung nach Anspruch 2 und das Verfahren nach Anspruch 14 haben den Vorteil, daß sich die auftretenden Zersetzungsprodukte in dem Hilfsrohr niederschlagen, das ausgebaut und leicht gereinigt werden kann.

Die Anordnung nach Anspruch 11 hat den Vorteil, daß der Ein-und Ausbau des Hilfsrohres besonders einfach handhabbar ist.

Das Verfahren nach Anspruch 13 hat den Vorteil, daß durch den Überdruck der leichterflüchtigen Komponente eine Oberflächenerosion während des Ausheilprozesses vermieden wird.

Weitere Ausgestaltungen der Erfindung gehen aus den übrigen Ansprüchen hervor.

Ausführungsbeispiele der Erfindung sind in FIG 1 bis FIG 4 dargestellt und werden im folgenden näher erläutert.

In FIG 1 ist eine Anordnung zum Durchführen eines Ausheilverfahrens dargestellt mit einem Reaktionsrohr und einem Hilfsrohr.

In FIG 2 bis FIG 4 sind verschiedene Varianten der Grundheizung, mit der die Grundtemperatur eingestellt wird, gezeigt.

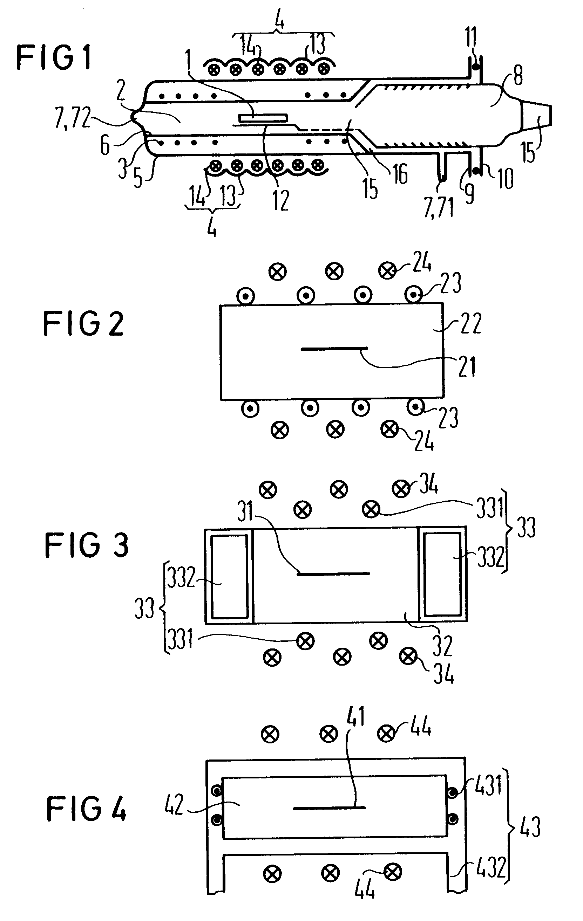

FIG 2 zeigt eine Anordnung, bei der die Grundtemperatur durch eine Widerstandsheizung hergestellt wird.

FIG 3 zeigt eine Anordnung bei der von Lampen bestrahlte und erwärmte Graphitblöcke als Heizung für die Grundtemperatur vorgesehen sind.

In FIG 4 ist eine Anordnung dargestellt, bei der die Grundtemperatur durch eine Widerstandsheizung eingestellt wird und bei der mit Hilfe einer Gasströmung im Umluftbetrieb für eine homogene Temperaturverteilung an der Kammerinnenwand gesorgt wird.

Es ist ein Reaktionsrohr 2 vorgesehen, in dem auf einer Aufnahme 12 eine auszuheilende Halbleiterscheibe 1 liegt (siehe FIG 1). Das Reaktionsrohr 2 ist im Bereich vor, um und nach der Halbleiterscheibe 1 doppelwandig. In dem Zwischenraum zwischen einer Innenwand 6 und einer Außenwand 5 ist eine Grundheizung 3 eingearbeitet. Die Grundheizung 3 besteht z. B. aus einer elektrischen Widerstandsheizung. Das Reaktionsrohr 2 weist zwei Gaseinlässe 7 auf. Die beiden Gaseinlässe 7 befinden sich so an dem Reaktionsrohr 2, daß die Halbleiterscheibe 1 zwischen den beiden Gaseinlässen 7 liegt. Auf einer Seite des Reaktionsrohres 2 ist ein Reaktionsrohrflansch 9 vorgesehen. Das Reaktionsrohr 2 besteht aus Quarzglas. Im Bereich der Halbleiterscheibe 1 ist außerhalb des Reaktionsrohres 2 eine selektive Heizung 4 vorgesehen. Die selektive Heizung 4 besteht aus Lampen 14 und Reflektoren 13. Die Lampen 14 und die Reflektoren 13 sind so angeordnet, daß das Licht auf die Halbleiterscheibe 1 gerichtet ist.

Es ist ein Hilfsrohr 8 vorgesehen. Das Hilfsrohr 8 ist mit zwei, an entgegengesetzten Seiten liegenden Öffnungen 15 versehen. Das Hilfsrohr 8 trägt einen Hilfsrohrflansch 10. Der Hilfsrohrflansch 10 ist so angeordnet, daß die vom Hilfsrohrflansch 10 umschlossene Fläche die Verbindungslinie der Öffnungen 15 schneidet und daß die Flächennormale der vom Hilfsrohrflansch 10 umschlossenen Fläche parallel zur Verbindungslinie der Öffnungen 15 verläuft.

Das Hilfsrohr 8 ist so bemessen, daß es in das Reaktionsrohr 2 von der Seite des Reaktionsrohrflansches 9 aus hineingesteckt werden kann. Dabei weist die Dichtfläche des Reaktionsrohrflansches 9 auf die Dichtfläche des Hilfsrohrflansches 10.

Zwischen dem Reaktionsrohrflansch 9 und dem Hilfsrohrflansch 10 liegt ein Dichtungsring 11, der durch Anpressen des Reaktionsrohrflansches 9 und des Hilfsrohrflansches 10 die Verbindung aus Reaktionsrohr 2 und Hilfsrohr 8 dichtet.

Das Hilfsrohr 8 ist ferner so bemessen, daß an der dem Reaktionsrohr 2 zugewandten Seite zwischen Reaktionsrohr 2 und Hilfsrohr 8 ein Zwischenraum 16 entsteht, an dem ein dem Reaktionsrohrflansch 9 zugewandter erster Gaseinlaß 71 angebracht ist. Durch den Zwischenraum 16 kann über den dem Reaktionsrohrflansch 9 zugewandten ersten Gaseinlaß 71 eingeleitetes Inertgas zu der dem Reaktionsrohr 2 zugewandten Öffnung 15 des Hilfsrohres 8 strömen. Über die dem Reaktionsrohr 2 abgewandte Öffnung 15 wird Gas einem Entsorgungssystem zugeführt.

In FIG 2 bis FIG 4 sind verschiedene Ausführungsbeispiele für die Grundheizung 3 dargestellt.

FIG 2 zeigt einen Schnitt durch ein zweites Reaktionsrohr 22 aus Quarzglas senkrecht zu der Zeichenebe in der FIG 1, senkrecht zu einer auszuheilenden zweiten Halbleiterscheibe 21 in dem Bereich, in dem die zweite Halbleiterscheibe 21 liegt.

Das zweite Reaktionsrohr 22 ist einfachwandig. Oberhalb und unterhalb der zweiten Halbleiterscheibe 21 ist eine zweite Grundheizung 23 auf der Außenseite des zweiten Reaktionsrohrs 22 aufgebracht. Die zweite Grundheizung 23 besteht aus einer elektrischen Widerstandsheizung. In zweiter Reihe hinter der zweiten Grundheizung 23 ist eine zweite selektive Heizung 24 angeordnet. Die zweite selektive Heizung 24 besteht wie die selektive Heizung 4 im ersten Ausführungsbeispiel aus einer Lampenanordnung. Die Anordnung der zweiten Grundheizung 23 und der zweiten selektiven Heizung 24 ist der Gestalt, daß die elektrische Widerstandsheizung auf Lücke mit den Lampen angeordnet ist. Dadurch werden Temperaturinhomogenitäten, die durch Schatten auf der zweiten Halbleiterscheibe hervorgerufen werden, vermindert. Im übrigen ist die Anordnung analog der Anordnung des ersten Ausführungsbeispiels aufgebaut.

In FIG 3 ist als weiteres Ausführungsbeispiel ein drittes Reaktionsrohr 32 aus Quarzglas mit einer auszuheilenden dritten Halbleiterscheibe 31 in derselben Ansicht wie das Ausführungsbeispiel in FIG 2 dargestellt. Seitlich der dritten Halbleiterscheibe 31 ist auf beiden Seiten in die Wand des dritten Reaktionsrohres 32 je ein Graphitblock 332 eingekapselt. Die Wände des Reaktionsrohrs 32 oberhalb und unterhalb der dritten Halbleiterscheibe 31 sind einfach. Oberhalb und unterhalb der dritten Halbleiterscheibe 31 sind Grundtemperaturlampen 331 in einer ersten Reihe angeordnet. Die Grundtemperaturlampen 331 und die Graphitblöcke 332 bilden zusammen die dritte Grundheizung 33. Mit den Grundtemperaturlampen 331 werden die Graphitblöcke 332 bestrahlt. Die Graphitblöcke 332 wirken als schwarze Strahler und verwandeln das Licht in Wärme. In zweiter Reihe ist eine dritte selektive Heizung 34 angeordnet. Die dritte selektive Heizung 34 besteht aus Lampen, die so angeordnet sind, daß die Grundtemperaturlampen 331 bei der Aufheizung der dritten Halbleiterscheibe 31 auf Ausheiltemperatur nicht stören.

Im übrigen ist die Anordnung analog der Anordnung des ersten Ausführungsbeispiels aufgebaut.

In FIG 4 ist als weiteres Ausführungsbeispiel ein viertes Reaktionsrohr 42 aus Quarzglas mit einer auszuheilenden vierten Halbleiterscheibe 41 und einer vierten Grundheizung 43 in derselben Ansicht wie das Ausführungsbeispiel in FIG 2 dargestellt. Das vierte Reaktionsrohr 42 ist doppelwandig ausgeführt. Die Wand des vierten Reaktionsrohres 42 ist mit zwei Heizeinlässen 432 versehen.

In die Wand des Reaktionsrohrs 42 ist seitlich der vierten Halbleiterscheibe 41 eine elektrische Widerstandsheizung 431 eingearbeitet. Eine vierte selektive Heizung 44 ist ober- und unterhalb der vierten Halbleiterscheibe 41 außerhalb des vierten Reaktionsrohres 42 angebracht. Die vierte selektive Heizung 44 besteht wiederum aus einer Lampenanordnung. Um im vierten Reaktionsrohr 42 eine homogene Temperaturverteilung zu erhalten, zirkuliert in der Wand des vierten Reaktionsrohres 42 ein Heizmedium, z. B. eine Inertgasströmung, das über die Heizeinlässe 432 eingeleitet wird. Als Heizmedium kann z. B. eine thermostatisierte Flüssigkeit verwendet werden, die ohne die elektrische Widerstandsheizung 431 die Grundtemperatur des vierten Reaktionsrohrs 42 einstellt.

Im übrigen ist die Anordnung analog der Anordnung des ersten Ausführungsbeispiels aufgebaut. Der Vorteil dieses Ausführungsbeispiels liegt darin, daß beim Einschalten der vierten selektiven Heizung 44 keine Schatten auf die vierte Halbleiterscheibe 41 geworfen werden.

Anhand von FIG 1 wird nun das Verfahren zum Ausheilen von Halbleiterscheiben beschrieben. Das Verfahren kann völlig analog in einer Anordnung entsprechend den anderen Ausführungsbeispielen ablaufen.

Das Reaktionsrohr 2 wird mit einem dem Reaktionsrohrflansch 9 abgewandten zweiten Gaseinlaß 72 an ein regelbares Gasversorgungssystem angeschlossen. Mit dem dem Reaktionsrohrflansch 9 zugewandten ersten Gaseinlaß 71 wird das Reaktionsrohr 2 an ein weiteres Gasversorgungssystem angeschlossen. Auf die Aufnahme 12 wird die Halbleiterscheibe 1 gelegt. Die Halbleiterscheibe 1 besteht z. B. aus einer III-V-Verbindung, insbesondere aus GaAs. Auf die Dichtfläche des Reaktionsrohrflansches 9 wird der Dichtungsring 11 gelegt. In das Reaktionsrohr 2 wird das Hilfsrohr 8 so eingeschoben, daß die Dichtfläche des Hilfsrohrflansches 10 in Richtung der Dichtfläche des Reaktionsrohrflansches 9 zeigt. Die Verbindung zwischen Reaktionsrohr 2 und Hilfsrohr 8 wird durch Pressen des Dichtungsrings 11 gedichtet. Das Hilfsrohr 8 wird über die dem Reaktionsrohr 2 abgewandte Öffnung 15 an ein Gasentsorgungssystem angeschlossen.

Über den zweiten Gaseinlaß 72 wird ein Inertgas in das Reaktionsrohr 2 geleitet. Damit wird eine Schutzgasatmosphäre geschaffen. Als Schutzgas

kann z. B. $N_2$ verwendet werden. Im Fall eines Verbindungshalbleiters ist es zweckmäßig, daß das Schutzgas eine Verbindung der leichterflüchtigen Komponente, insbesondere die Wasserstoffverbindung der leichterflüchtigen Komponente, enthält. Im Fall eines III-V-Halbleiters, z. B. GaAs, wird eine gasförmige V-Verbindung, insbesondere V-Hydrid, z. B. $AsH_3$, verwendet.

Über die Grundheizung 3 wird die Grundtemperatur im Reaktionsrohr 2 eingestellt. Die Grundtemperatur wird so gewählt, daß der Ausheilprozeß der Halbleiterscheibe 1 noch nicht einsetzt. Die Grundtemperatur wird ferner so gewählt, daß keine Wandbelegungen durch niedergeschlagenes Material auftreten. Im Fall eines Verbindungshalbleiters wird die Grundtemperatur so gewählt, daß sich das Schutzgas zersetzt. Wird z. B. mit $AsH_3$ gearbeitet, genügt eine Grundtemperatur von etwa 300°C (oder mehr), um das Hydrid zu zersetzen. Durch das Zersetzen bildet sich ein Überdruck der leichterflüchtigen Komponente, z. B. $As_2$ und $As_4$. Der Überdruck der leichterflüchtigen Komponente wird über den regelbaren Druck des Schutzgases und evtl. das Mischungsverhältnis so eingestellt, daß ein Abdampfen der leichterflüchtigen Komponente während des Ausheilprozesses verhindert wird. Über den ersten Gaseinlaß 71 wird ein weiteres Inertgas, z. B. $N_2$, eingeleitet. Das weitere Inertgas wird unter solchem Druck eingeleitet, daß eine Strömung entsteht, die die entstehenden Zersetzungsprodukte des Schutzgases in das Hilfsrohr 8 leitet. Im Hilfsrohr 8 schlagen sich die Zersetzungsprodukte nieder.

Die selektive Heizung 4, mit der die Halbleiterscheibe 1 auf Ausheiltemperatur gebracht wird, wird eingeschaltet. Als selektive Heizung 4 werden z. B. starke weiße Lampen, insbesondere Halogenlampen, verwendet. Die Halbleiterscheibe 1 wird sehr schnell, z. B. mit $10^3$ °C/sek. auf die Ausheiltemperatur von z. B. 900°C aufgeheizt. Der Ausheiltemperatur wird die Halbleiterscheibe 1 für etwa 5 bis 20 Sek. ausgesetzt. Dann wird die selektive Heizung 4 abgeschaltet. Wenn die Halbleiterscheibe 1 die Grundtemperatur wieder erreicht hat, wird die Grundheizung 3 abgeschaltet. Nachdem die Anordnung wieder Zimmertemperatur erreicht hat, wird das Schutzgas und das weitere Inertgas abgeschaltet. Das Reaktionsrohr 2 und das Hilfsrohr 8 werden mit einem ungiftigen Inertgas wie z. B. $N_2$ gespült, insbesondere wenn das Schutzgas giftige Komponenten wie z. B. $AsH_3$ enthält.

Das Hilfsrohr 8 wird ausgebaut und von den Zersetzungsprodukten gereinigt. Die Halbleiterscheibe 1 wird dem Reaktionsrohr 2 entnommen.

Mit dem Verfahren können mehrere Halbleiterscheiben 1 gleichzeitig ausgeheilt werden, wenn die Aufnahme 12 mit mehreren Halbleiterscheiben 1 auf einmal bestückt wird.

**Patentansprüche**

1. Anordnung zur Durchführung eines Ausheilprozesses an einer Halbleiterscheibe mit folgenden Merkmalen:

   a) es ist ein Reaktionsrohr (2) zur Aufnahme der Halbleiterscheibe (1) vorgesehen,

   b) an dem Reaktionsrohr (2) sind mindestens ein Gaseinlaß (7) und eine Öffnung (15) als Gasauslaß vorgesehen,

   c) es ist eine an dem Reaktionsrohr (2) angeordnete Grundheizung (3) vorhanden, mit der die Wände des Reaktionsrohres (2) auf eine Grundtemperatur aufheizbar sind,

   d) es ist eine von dieser Grundheizung getrennte selektive Heizung (4) zum Aufheizen der Halbleiterscheibe (1) auf Ausheiltemperatur vorgesehen.

2. Anordnung nach Anspruch 1, **gekennzeichnet** durch folgende Merkmale:

   a) es ist ein Hilfsrohr (8) vorgesehen, das an das Reaktionsrohr (2) angeschlossen werden kann,

   b) an der Ansatzstelle zwischen Hilfsrohr (8) und Reaktionsrohr (2) ist mindestens ein Gaseinlaß (71) vorgesehen,

   c) die Ansatzstelle zwischen Hilfsrohr (8) und Reaktionsrohr (2) ist so gestaltet, daß über den Gaseinlaß (71) ein Inertgasgegenstrom erzeugt werden kann, der im Reaktionsrohr (2) auftretende Zersetzungsprodukte in das Hilfsrohr (8) lenkt.

3. Anordnung nach Anspruch 2, dadurch **gekennzeichnet,** daß das Hilfsrohr (8) in das Reaktionsrohr (2) hineinsteckbar ist, daß das Hilfsrohr (8) und das Reaktionsrohr (2) an der Seite, an der sie aufeinandertreffen, je ein Flanschteil (9, 10) aufweisen und daß ein Dichtungsring (11) vorgesehen ist, der bei den zusammengesteckten Hilfsrohr (8) und Reaktionsrohr (2) zwischen die beiden Flanschteile (9, 10) eingequetscht ist und die Anschlußstelle dichtet.

4. Anordnung nach einem der Ansprüche 1 bis 3, dadurch **gekennzeichnet,** daß das Reaktionsrohr (2) aus Quarzglas besteht.

5. Anordnung nach einem der Ansprüche 1 bis 4, dadurch **gekennzeichnet,** daß an den Innenseiten von Wänden des Reaktionsrohres als Grundheizung eine Widerstandsheizung eingebaut ist.

**6.** Anordnung nach einem der Ansprüche 1 bis 4, dadurch **gekennzeichnet,** daß an den Außenseiten von Wänden des Reaktionsrohrs (22) als Grundheizung (23) eine Widerstandsheizung eingebaut ist.

**7.** Anordnung nach Anspruch 4, dadurch **gekennzeichnet,** daß als Grundheizung (3) ein schwarzer Körper vorgesehen ist, der in das Reaktionsrohr (2) eingebaut ist, und daß Lampen vorgesehen sind zur Bestrahlung des schwarzen Körpers, der das Licht absorbiert und in Wärme umwandelt.

**8.** Anordnung nach Anspruch 4, dadurch **gekennzeichnet,** daß das Reaktionsrohr (2) im Bereich vor, um und nach der auszuheilenden Halbleiterscheibe (1) doppelwandig ausgeführt ist.

**9.** Anordnung nach Anspruch 8, dadurch **gekennzeichnet,** daß die Grundheizung (3) aus einer thermostatisierten Flüssigkeit besteht, die sich in dem Zwischenraum der Doppelwände des Reaktionsrohres (2) befindet.

**10.** Anordnung nach Anspruch 8, dadurch **gekennzeichnet,** daß die Grundheizung (3) aus einer in den Zwischenraum der Doppelwände eingearbeiteten elektrischen Widerstandsheizung besteht, die die Fläche oberhalb und unterhalb der auszuheilenden Halbleiterscheibe (1) freiläßt, und daß die Innenwand (6) des Reaktionsrohrs (2) mit Hilfe einer Gasströmung im Umluftbetrieb homogen auf der Grundtemperatur gehalten werden kann.

**11.** Anordnung nach einem der Ansprüche 1 bis 10, dadurch **gekennzeichnet,** daß als selektive Heizung (4) für das Ausheilen der Halbleiterscheibe (1) Lampen (14) vorgesehen sind.

**12.** Verfahren zum Ausheilen einer Halbleiterscheibe mit folgenden Schritten:
a) die Halbleiterscheibe (1) wird in ein Reaktionsrohr (2) eingelegt,
b) das Reaktionsrohr (2) wird an ein regelbares Gasversorgungssystem angeschlossen, gedichtet und mit Inertgas gefüllt,
c) die Wände des Reaktionsrohrs (2) werden auf eine Grundtemperatur aufgeheizt, die so hoch ist, daß sich kein abgedampftes Material auf den Wänden niederschlägt und so niedrig, daß der Ausheilprozeß noch nicht in Gang kommt,

d) die Halbleiterscheibe (1) wird mit einer selektiven Heizung (4) für einige Sekunden selektiv auf die Ausheiltemperatur aufgeheizt,
e) die Apparatur wird auf Zimmertemperatur abgekühlt und die Halbleiterscheibe (1) ausgebaut.

**13.** Verfahren nach Anspruch 12, dadurch **gekennzeichnet,** daß die Halbleiterscheibe (1) aus einem Verbindungshalbleiter, insbesondere einer III-V-Verbindung, besteht, daß das Inertgas eine gasförmige Verbindung der leichterflüchtigen Komponente der Verbindung enthält, insbesondere die Wasserstoffverbindung der leichterflüchtigen Komponente, und daß die Grundtemperatur so hoch ist, daß sich die gasförmige Verbindung der leichterflüchtigen Komponente in ihre Bestandteile zersetzt und einen Überdruck der leichterflüchtigen Komponente erzeugt.

**14.** Verfahren nach Anspruch 12 oder 13, **gekennzeichnet** durch folgende Schritte:
a) nach dem Einlegen der Halbleiterscheibe (1) in das Reaktionsrohr (2) wird das Reaktionsrohr (2) mit einem Hilfsrohr (8) vakuumdicht verbunden,
b) Zersetzungsprodukte des Inertgases werden durch einen Gegenstrom eines weiteren Inertgases in das Hilfsrohr (8) geleitet, wo sie sich niederschlagen,
c) nachdem die Apparatur auf Zimmertemperatur abgekühlt ist, wird das Hilfsrohr (8) zur Reinigung ausgebaut.

**15.** Verfahren nach einem der Ansprüche 12 bis 14, dadurch **gekennzeichnet,** daß die Grundtemperatur durch eine Widerstandsheizung eingestellt wird.

**16.** Verfahren nach einem der Ansprüche 12 bis 14, dadurch **gekennzeichnet,** daß die Grundtemperatur durch einen schwarzen Strahler eingestellt wird.

**17.** Verfahren nach einem der Ansprüche 12 bis 14, dadurch **gekennzeichnet,** daß die Grundtemperatur durch eine thermostatisierte Flüssigkeit eingestellt wird.

**18.** Verfahren nach einem der Ansprüche 12 bis 17, dadurch **gekennzeichnet,** daß die Ausheiltemperatur der Halbleiterscheibe (1) durch Bestrahlung der Halbleiterscheibe (1) mit Lampen (14) eingestellt wird.

## Claims

1. Apparatus for carrying out an annealing process on a semiconductor wafer having the following features:

    a) a reaction tube (2) is provided for receiving a semiconductor wafer (1),

    b) at least one gas inlet (7) and one opening (15) as gas outlet are provided on the reaction tube (2)

    c) a background heater (3) is present which is situated on the reaction tube (2) and with which the walls of the reaction tube (2) can be heated to a base temperature,

    d) a selective heater (4) is provided which is separate from said background heater and is for heating the semiconductor wafer (1) to the annealing temperature.

2. Apparatus according to Claim 1, characterised by the following features:

    a) an auxiliary tube (8) is provided which can be connected to the reaction tube (2),

    b) at least one gas inlet (71) is provided at the attachment point between auxiliary tube (8) and reaction tube (2),

    c) the attachment point between auxiliary tube (8) and reaction tube (2) is so constructed that an inert gas counter-current can be generated via the gas inlet (71), said inert gas counter-current guiding decomposition products produced in the reaction tube (2) into the auxiliary tube (8).

3. Apparatus according to Claim 2, characterised in that the auxiliary tube (8) can be inserted into the reaction tube (2), in that the auxiliary tube (8) and the reaction tube (2) each have a flange part (9, 10) at the end where they meet one another, and in that a sealing ring (11) is provided which is pinched between the two flange parts (9, 10) when the auxiliary tube (8) and the reaction tube (2) are assembled and seals the connecting point.

4. Apparatus according to one of Claims 1 to 3, characterised in that the reaction tube (2) is composed of quartz glass.

5. Apparatus according to one of Claims 1 to 4, characterised in that a resistance heater is built in as background heater on the insides of walls of the reaction tube.

6. Apparatus according to one of Claims 1 to 4, characterised in that a resistance heater is built in as background heater (23) on the outsides of walls of the reaction tube (22).

7. Apparatus according to Claim 4, characterised in that, as background heater (3), a black body is provided which is built into the reaction tube (2), and in that lamps are provided for irradiating the black body, which absorbs the light and converts it into heat.

8. Apparatus according to Claim 4, characterised in that the reaction tube (2) is of double-walled construction in the region upstream of, around and downstream of the semiconductor wafer (1) to be annealed.

9. Apparatus according to Claim 8, characterised in that the background heater (3) is composed of a thermostatted liquid which is situated in the gap in the double walls of the reaction tube (2).

10. Apparatus according to Claim 8, characterised in that the background heater (3) comprises an electrical resistance heater which is incorporated in the gap in the double walls and which leaves free the area above and below the semiconductor wafer (1) to be annealed, and in that the inside wall (6) of the reaction tube (2) can be maintained homogenously at the base temperature with the aid of a circulating gas flow.

11. Apparatus according to one of Claims 1 to 10, characterised in that lamps (14) are provided as selective heater (4) for annealing the semiconductor wafer (1).

12. Process for annealing a semiconductor wafer comprising the following steps:

    a) the semiconductor wafer (1) is placed in a reaction tube (2),

    b) the reaction tube (2) is connected to a controllable gas supply system, sealed and filled with inert gas,

    c) the walls of the reaction tube (2) are heated to a base temperature which is high enough for no evaporated material to precipitate on the walls and low enough for the annealing process not to be initiated as yet,

    d) the semiconductor wafer (1) is selectively heated to the annealing temperature for a few seconds with a selective heater (4),

    e) the apparatus is cooled to room temperature and the semiconductor wafer (1) is removed.

13. Process according to Claim 12, characterised in that the semiconductor wafer (1) is composed of a compound semiconductor, in particular a III-V compound, in that the inert gas contains a gaseous compound of the more readily volatile component, in particular the hydrogen compound of the more readily volatile compound, and in that the base temperature is high enough for the gaseous compound of the more readily volatile component to be decomposed into its constituents and produce an overpressure of the more readily volatile component.

14. Process according to Claim 12 or 13, characterised by the following steps:

a) after the semiconductor wafer (1) has been placed in the reaction tube (2), the reaction tube (2) is connected to an auxiliary tube (8) in a vacuum-tight manner,

b) decomposition products of the inert gas are conveyed by a counter-current of a further inert gas into the auxiliary tube (8), where they precipitate,

c) after the apparatus has cooled to room temperature, the auxiliary tube (8) is removed for cleaning.

15. Process according to one of Claims 12 to 14, characterised in that the base temperature is established by a resistance heater.

16. Process according to one of Claims 12 to 14, characterised in that the base temperature is established by a black radiator.

17. Process according to one of Claims 12 to 14, characterised in that the base temperature is established by a thermostatted liquid.

18. Process according to one of Claims 12 to 17, characterised in that the annealing temperature of the semiconductor wafer (1) is established by irradiating the semiconductor water (1) with lamps (14).

**Revendications**

1. Dispositif pour appliquer une opération de recuit à une pastille semiconductrice, présentant les caractéristiques suivantes :

a) il est prévu un tube réactionnel (2) servant à loger la pastille semiconductrice (1),

b) il est prévu, dans le tube réactionnel (2), au moins une entrée (7) pour le gaz et une ouverture (15) en tant que sortie pour le gaz,

c) il est prévu un dispositif de chauffage de base (3), qui est disposé sur le tube réactionnel (2) et au moyen duquel les parois de ce tube peuvent être chauffées à une température de base,

d) il est prévu un dispositif de chauffage sélectif (4) séparé de ce dispositif de chauffage de base et servant à chauffer la pastille semiconductrice (1) à une température de recuit.

2. Dispositif suivant la revendication 1, caractérisé par les particularités suivantes :

a) il est prévu un tube auxiliaire (8), qui peut être raccordé au tube réactionnel (2),

b) au moins une entrée (71) pour le gaz est prévue au niveau de la zone de jonction entre le tube auxiliaire (8) et le tube réactionnel (2),

c) la zone de jonction entre le tube auxiliaire (8) et le tube réactionnel (2) est agencée de telle sorte que par l'intermédiaire de l'entrée (71) pour le gaz on peut former un courant antagoniste de gaz inertes, qui dirige les produits de dissociation, qui apparaissent dans le tube réactionnel (2), dans le tube auxiliaire (8).

3. Dispositif suivant la revendication 2, caractérisé par le fait que le tube auxiliaire (8) peut être enfiché dans le tube réactionnel (2), que le tube auxiliaire (8) et le tube réactionnel (2) possèdent respectivement une partie formant bride (9,10) sur le côté, sur lequel ils se rejoignent, et qu'il est prévu une bague d'étanchéité (11) qui, lorsque le tube auxiliaire (8) et le tube réactionnel (2) sont enfichés l'un dans l'autre, est serrée entre les deux éléments de bride (9,10) et étanchéifie la zone de raccordement.

4. Dispositif suivant l'une des revendications 1 à 3, caractérisé par le fait que le tube réactionnel (2) est formé de verre quartzeux.

5. Dispositif suivant l'une des revendications 1 à 4, caractérisé par le fait qu'un dispositif de chauffage à résistance est monté dans les faces intérieures de parois du tube réactionnel, en tant que dispositif de chauffage de base.

6. Dispositif suivant l'une des revendications 1 à 4, caractérisé par le fait qu'un dispositif de chauffage à résistance est monté, en tant que dispositif de chauffage de base (23), dans les faces extérieures de parois du tube réactionnel (22).

**7.** Dispositif suivant la revendication 4, caractérisé par le fait qu'il est prévu, comme dispositif de chauffage de base (3), un corps noir, qui est monté dans le tube réactionnel (2) et qu'il est prévu des lampes servant à éclairer le corps noir qui absorbe la lumière et la convertit en chaleur.

**8.** Dispositif suivant la revendication 4, caractérisé par le fait que le tube réactionnel (2) est réalisé avec une double paroi dans la zone située en avant, autour et en arrière de la pastille semiconductrice (1) devant être soumise à un recuit.

**9.** Dispositif suivant la revendication 8, caractérisé par le fait que le dispositif de chauffage de base (3) est constitué par un liquide thermostaté, qui est situé dans l'espace compris entre les parois doubles du tube réactionnel (2).

**10.** Dispositif suivant la revendication 8, caractérisé par le fait que le dispositif de chauffage de base (3) est constitué par un dispositif de chauffage électrique à résistance, qui est monté dans l'espace compris entre les doubles parois et qui libère la surface située au-dessus et au-dessous de la pastille semiconductrice (1) devant être soumise à un recuit, et que la paroi intérieure (6) du tube réactionnel (2) peut être maintenue d'une manière homogène à la température de base à l'aide d'un écoulement de gaz enveloppant.

**11.** Dispositif suivant l'une des revendications 1 à 10, caractérisé par le fait qu'il est prévu des lampes (14) comme dispositif de chauffage sélectif (4) pour le recuit de la pastille semiconductrice (1).

**12.** Procédé pour réaliser le recuit d'une pastille semiconductrice, comprenant les étapes suivantes :
a) on insère la pastille semiconductrice (1) dans un tube réactionnel (2),
b) on raccorde le tube réactionnel (2) à un système d'alimentation réglable en gaz, on le ferme de façon étanche et on le remplit d'un gaz inerte,
c) on chauffe les parois du tube réactionnel (2) à une température de base qui est suffisamment élevée pour qu'aucun matériau évaporé ne se dépose sur les parois, et suffisamment faible pour que le processus de recuit ne soit pas encore mis en oeuvre,

d) on chauffe de façon sélective, pendant quelques secondes, la pastille semiconductrice (1) à la température de recuit, à l'aide d'un dispositif de chauffage sélectif (4),
e) on refroidit l'appareillage à la température ambiante et on retire la pastille semiconductrice (1).

**13.** Procédé suivant la revendication 12, caractérisé par le fait que la pastille semiconductrice (1) est constituée par un semiconducteur composite, notamment un composé III-V, que le gaz inerte contient un composé gazeux du composant plus volatil du composé, notamment le composé hydrogéné du composant le plus volatil, et que la température de base est suffisamment élevée pour que le composé gazeux du composant le plus volatil se dissocie en ses constituants et produise une surpression du composant le plus volatil.

**14.** Procédé suivant la revendication 12 ou 13, caractérisé par les étapes suivantes :
a) après insertion de la pastille semiconductrice dans le tube réactionnel (2), on raccorde ce dernier à un tube auxiliaire (8), d'une manière étanche au vide,
b) des produits de dissociation du gaz inerte sont envoyés, au moyen d'un contre-courant d'un autre gaz inerte, dans le tube auxiliaire (8), où ils se déposent,
c) on refroidit ensuite l'appareillage à la température ambiante et on retire le tube auxiliaire (8) pour le nettoyer.

**15.** Procédé suivant l'une des revendications 12 à 14, caractérisé par le fait qu'on règle la température de base au moyen d'un dispositif de chauffage à résistance.

**16.** Procédé suivant l'une des revendications 12 à 14, caractérisé par le fait qu'on règle la température de base au moyen d'un émetteur noir.

**17.** Procédé suivant l'une des revendications 12 à 14, caractérisé par le fait qu'on règle la température de base au moyen d'un liquide thermostaté.

**18.** Procédé suivant l'une des revendications 12 à 17, caractérisé par le fait qu'on règle la température de recuit de la pastille semiconductrice (1) par irradiation de cette pastille semiconductrice (1) au moyen de lampes (14).

FIG 1

FIG 2

FIG 3

FIG 4